# EUROPEAN PATENT APPLICATION

(11) **EP 4 841 334 A1**
(43) Date of publication of application: **18.11.2026**
(21) Application number: 26178921.8
(22) Date of filing: 15.05.2026
(51) Int. Cl.: G02F 1/015, G02F 1/017, G02F 1/025

(54) **SERIES DIFFERENTIAL ELECTRO-ABSORPTION MODULATOR, LASER SYSTEMS INCORPORATING SAME, AND METHODS OF MAKING SAME**

(30) Priority: 16.05.2025 US 202563807292 P
(71) Applicant: II-VI Delaware, Inc., Wilmington, DE 19890 (US)
(72) Inventor: Adams, David, Wilmington, 19890 (US); Kaikkonen, Andrei, Wilmington, 19890 (US); Lundqvist, Lennart, Wilmington, 19890 (US)
(74) Representative: Bosch Jehle Patentanwaltsgesellschaft mbH

(57) **Abstract**

Disclosed here are optical transmitting devices that include series differential electro-absorption modules and methods of making same. In some examples, the optical transmitting devices include an optical source, a first electro-absorption modulator (EAM) having a first semiconductor layer over the substrate and being doped with a first dopant type, a second semiconductor layer over the first semiconductor layer and being doped with a second dopant type opposite the first dopant type, and an active region between the first semiconductor layer and the second semiconductor layer of the first EAM; a second EAM including a first semiconductor layer over the substrate and being doped with the second dopant type, a second semiconductor layer over the first semiconductor layer and being doped with the first dopant type, and an active region between the first semiconductor layer and the second semiconductor layer of the second EAM.

## Description

### CROSS-REFERENCE TO RELATED APPLICATIONS

This application claims priority to and the benefit of U.S. Provisional Patent Application No. 63/807,292 filed May 16, 2025, titled SERIES DIFFERENTIAL ELECTRO-ABSORPTION MODULATOR, LASER SYSTEMS INCORPORATING SAME, AND METHODS OF MAKING SAME, which is incorporated herein by reference in its entirety. This application incorporates by reference US Patent Application 19/095,912 filed on March 31, 2025, US Patent Application 19/095,904 filed on April 7, 2025, and PCT application PCT/US2025/02350 in each of their entirety (together, the "Differential electro-absorption-modulator (EAM) Applications").

### TECHNICAL FIELD

The present disclosure relates in general to modulation of an optical signal, for example, for transmission in an optical fiber. The disclosure relates in particular to rapid modulation of an optical signal by a differentially-driven electro-absorption modulator.

### BACKGROUND

Optical fibers are ubiquitous for high-speed data transmission. There are optical transmitters and optical receivers at each end of an optical fiber to convert an electrical signal to an optical signal for transmission and to convert a received optical signal to an electrical signal. A transmitter typically includes a laser to produce a laser beam that will be encoded with the data signal to be transmitted. The data signal may be digital, a pulse amplitude modulation (PAM), or otherwise encoded. The data signal may be impressed on the laser beam by directly modulating the electrical signal driving the laser or by modulating the power of the laser beam itself using an optical modulator. The latter has the optical modulator arranged to intercept the laser beam and is known as an "externally modulated laser" (EML). In an "electro-absorption modulator" (EAM), an electrical drive signal regulates its optical absorption, thereby impressing a data signal onto a laser beam that is partially transmitted therethrough.

There may be additional components at each end of the optical fiber, such as optical switches, multiplexers, and demultiplexers. There may be components between each end, particularly fiber amplifiers, which periodically amplify laser beams guided within a long optical fiber. In commercial implementations, the optical transmitter(s) and optical receiver(s) at each end of the optical fiber may be integrated into a single device called an "optical transceiver". Currently, optical transceivers are commercially available at data rates of up to 800 Gb/s (gigabits per second). For example, from Coherent Corp. of Saxonburg, Pennsylvania.

### BRIEF SUMMARY

Disclosed here are optical transmitting devices. In one aspect of the disclosure, an optical transmitting device includes; an optical source adapted to emit an optical beam, a substrate, a first electro-absorption modulator (EAM) arranged on the substrate and configured to modulate the optical beam in response to an RF signal, where the first EAM includes a first semiconductor layer over the substrate and being doped with a first dopant type, a second semiconductor layer over the first semiconductor layer and being doped with a second dopant type opposite the first dopant type, and an active region between the first semiconductor layer and the second semiconductor layer of the first EAM, and a second EAM arranged on the substrate to receive the optical beam from the first EAM and configured to modulate the optical beam in response to an inverted signal of the RF signal, where the second EAM includes a first semiconductor layer over the substrate and being doped with the second dopant type, a second semiconductor layer over the first semiconductor layer and being doped with the first dopant type, and an active region between the first semiconductor layer and the second semiconductor layer of the second EAM.

In another aspect of the disclosure, where the first dopant type is n-type, the second dopant type is p-type, the first EAM is a P-i-N EAM, and the second EAM is an N-i-P EAM. In another aspect of the disclosure, the substrate is a doped substrate being doped with the first dopant type. In yet another aspect of the disclosure the optical source is arranged on the substrate. In another aspect of the disclosure, the second semiconductor layer of the first EAM is electrically connected to a first output of a differential amplifier, the second semiconductor layer of the second EAM is electrically connected to a second output of the differential amplifier and the second output toan inverted output of the first output. In yet another aspect of the disclosure, the active region of the P-i-N EAM and the active region of the N-i-P EAM forms a shared modulator active region. In another aspect of the disclosure, the second semiconductor layer of the P-i-N EAM is a p-doped ridge waveguide. In another aspect of the disclosure, an optical transmitting device further includes a P-i-N EAM anode formed over the p-doped ridge waveguide. In another aspect of the disclosure, an optical transmitting device further includes a contact layer between the P-i-N EAM anode and the p-doped ridge waveguide.

In one aspect of the disclosure, an optical transmitting device includes an exit facet, where the p-doped ridge waveguide increases in thickness in a direction toward the exit facet. In another aspect of the disclosure, the active region of the second EAM is tapered in a direction toward the exit facet. In another aspect of the disclosure, the first semiconductor layer of the N-i-P EAM is formed within a trench of the first semiconductor layer of the P-i-N EAM. In another aspect of the disclosure, the second semiconductor layer of the N-i-P EAM is an n-doped ridge waveguide. In yet another aspect of the disclosure, the n-doped ridge waveguide has a second step over a first step, the second step having a longitudinal extent that is shorter than the first step. In another aspect of the disclosure, an optical transmitting device includes an N-i-P EAM cathode formed over the n-doped ridge waveguide. In another aspect of the disclosure, an optical transmitting device further includes a contact layer between the N-i-P EAM cathode and the n-doped ridge waveguide. In another aspect of the disclosure, the first semiconductor layer of the first N-i-P EAM includes a first sub-layer over a second sub-layer and the first sub-layer has a higher concentration of the first dopant type than the second sub-layer. In another aspect of the disclosure, the optical source is a laser and includes an active region and the active region of the laser optically aligns with the active region of the first EAM. In another aspect of the disclosure, the second semiconductor layer of the first EAM is electrically connected to a first radio frequency (RF) termination network and the second semiconductor layer of the second EAM is electrically connected to a second RF termination network.

### BRIEF DESCRIPTION OF THE SEVERAL VIEWS OF THE DRAWINGS

FIG. 1 shows an analog circuit in accordance with embodiments of the disclosure.
FIGs. 2-3 show side and perspective view of a transmitting device in accordance with embodiments of the disclosure.
FIGs. 4-9 shows steps in forming a transmitting device in accordance with embodiments of the disclosure.
FIG. 10 illustrates an aspect of the subject matter in accordance with one embodiment.
FIGs. 11-13 show comparative performance metrics that have been computer simulated in accordance with embodiments of the disclosure.
FIGs. 14-16 show dynamic impedance performance computer simulations of embodiments of the disclosure.

### DETAILED DESCRIPTION

The market is demanding even faster optical transceivers, while maintaining high reliability, high efficiency, broad temperature tolerance, good wavelength control, minimal power consumption, and standard form factors. Another critical requirement is low cross talk between transmitter channels, between receiver channels, and between transmitter and receiver channels. A typical transceiver has four or eight transmitter channels and four or eight receiver channels. Cross talk increases bit error rate (BER) and effectively reduces receiver sensitivity. Cross talk generally increases with increasing data rates. There is need for EML designs that minimize cross talk to enable high performance optical transceivers at higher data rates.

The Differential electro-absorption-modulator (EAM) Applications disclose driving each modulator stage with both RF+ and RF- signals of a differential amplifier, i.e., where the RF positive (+) signal "pushes" and the inverse signal (RF negative (-)) signal "pulls" the same EAM modulator section. The present disclosure includes embodiments that drive a P-i-N EAM section with the RF+ signal and drives an optically connected N-i-P EAM section with the RF-signal. Described embodiments include both the EAM sections on the same substrate. For this disclosure "P," "i" or "I" and "N" are nomenclature for the conventional use of P being P-type doped, i (or "I") being intrinsic, and N being N-type doped semiconductors. While embodiments disclosed in the present application show one convention and order of the P-type material, i-type material, and N-type material (for example a P-i-N EAM section followed by an N-i-P EAM section) it should be noted that the P-i-N EAM section and N-i-P EAM sections may also be reversed such that each instance of an P-type material can be an N-type material with each instance of an N-type material being P-type. For example, an N-i-P EAM section followed by a P-i-N EAM could be disposed along the optical path.

While devices of the present disclosure could also be formed on insulated or semi-insulated substrates, the present disclosure can also achieve the benefits of the Differential EML Applications, but with additional advantages, for example formation on doped substrates in comparison to the insulated or semi-insulated substrates. Doped substrates, for example N-doped substrates, are more broadly available at low cost, and enable greater ease of monolithic integration with other components that are typically formed on doped substrates. Disclosed embodiments include a plurality of optically connected sequential EAM sections with opposing doping configurations. For example, disposing a P-i-N EAM section and a N-i-P EAM section following a laser, where each EAM section are modulated by different parts of a differential signal pair.

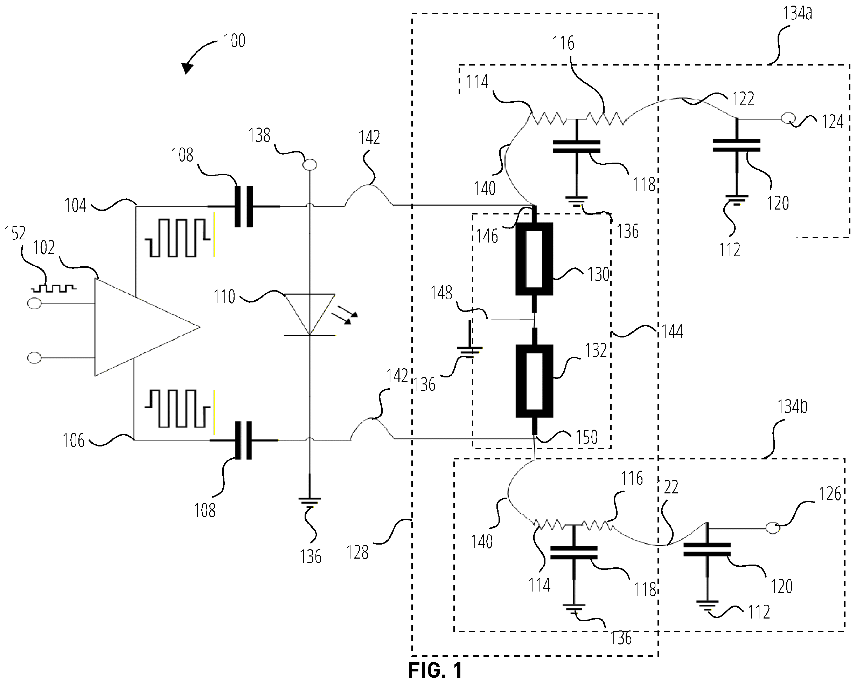

FIG. 1 shows a circuit 100 schematically illustrating one example embodiment of a laser transmitting device in accordance with the present disclosure, including an optical source 110, such as a laser, and an optical modulator 144 having a first modulator section (P-i-N EAM) 130 and second modulator section (N-i-P EAM) 132, the first and second modulator sections (130,132) having doped sections in opposite order, respectively from each other, and located on a common substrate. The circuit 100 provides a bias potential 124 for the RF+ (positive) signal, a bias potential 126 for the RF- (negative) signal, respective RF termination networks (134a, 134b) for each of the RF+ and RF- signals, and a differential amplifier 102, e.g., an operational amplifier, applying a rapidly-modulated electric potential differentially across the optical modulator 144.

The optical source 110, in one example, is fabricated on the same substrate as the optical modulator 144 to minimize optical losses between the optical source 110 and the optical modulator 144 (first and second modulator sections 130, 132). The optical source 110 and the first and second modulator sections 130, 132 can be coupled together optically via a single waveguide when both the optical source 110 and the optical first and second modulator sections 130, 132 are co-located on the same substrate, as described below. Waveguide optical coupling is less vulnerable to mechanical instabilities compared to free-space optical coupling. However, other implementations that couple the optical source 110 to the optical modulator 144 using an independent waveguide or free space are also suitable (whether or not the optical source 110 is located on the same substrate), albeit not as efficient.

The optical source 110, e.g., a laser, can be driven by an electric potential between laser drive electric potential 138 and laser ground 136. For the remainder of the application, optical source 110 will be referred to (by example only) as a laser. In general, the electric potential between laser drive electric potential 138 and laser ground 136 can induce a direct current (DC) above the lasing threshold such that the optical source 110 produces a laser beam with about constant optical power. The optical source 110 can thereby produce a continuous wave laser beam. In some embodiments, the optical source 110 can be a semiconductor resonator (a laser diode). Alternatively, the optical source 110 can be a semiconductor optical amplifier, which amplifies a laser beam generated by a laser that may be located on the same substrate as such semiconductor optical amplifier or may be located remotely. A waveguide may couple the laser beam from the laser to such a semiconductor optical amplifier.

The optical modulators 130 and 132 are optically coupled to the laser source 106 to regulate / modulate transmission of the laser beam propagating therethrough by partially absorbing the laser beam, by partially reflecting the laser beam, or by changing a phase of the laser beam. Herein, for convenience of description, examples using absorption will be presented in detail.

A first bias driver (not depicted), may be inputted at bias potential 124, to provide a reverse bias electric potential V_{B}+ applied across P-i-N EAM 130, between node 146 and node 148. In operation, the bias potential is preferably constant. A second bias driver (not depicted), may be inputted at bias potential 126, to provide a reverse bias electric potential V_{B}-, which is applied across N-i-P EAM 132, between node 150 and node 148. In operation, the bias potential is preferably constant and set to achieve as high as possible optical modulation amplitude for the given optical input power and dynamic voltage swing, while also achieving sufficient junction depletion to provide an average junction capacitance that will enable the particular bandwidth requirement.

A differential amplifier 102 is configured to receive a modulating signal 152 and output and apply, simultaneously, a differential RF signal (signal 104 and inverted signal 106) to the optical modulator 144, with signal 104 being applied between node 146 and node 148 and inverted signal 106 (the inverse of signal 104) being applied between node 150 and node 148. A DC Block 108 (shown as capacitors) may be included to block DC signals in each of signal 104 and inverted signal 106 thereby only allowing alternating current (AC) signals to pass between the differential amplifier 102 and the optical modulator 144. The differential RF signal (104, 106) can comprise a data signal to be transmitted by circuit 100 to a remote receiver or transceiver circuit. Because the RF signals (104, 106) induce an electric potential between nodes 146 and 148, and 150 and 148, respectively, the optical modulator 144 modulates the transmission of the laser beam. The modulating signal 152 can comprise a data signal to be transmitted by the circuit 100.

In some embodiments, the RF signals 104,106 can be transmitted from a ceramic or silicon carrier to on-chip elements 128 via wire bonds 142. These wire bonds can generate inductance as the RF signals 104, 106 travel to the on-chip elements 128. Accordingly, the wire bonds 142 can be represented as inductors, or, equivalently, inductive connectors.

In some embodiments, the bias potentials 124, 126 (V_{B}+ and V_{B}-) can be selected so that the optical modulators 130, 132 produce the largest absorption and transmission changes in response to the modulated potential applied by differential amplifier 102. That condition would typically correspond to a reverse bias potential V_{B} of about -1V to -3V. Each bias potential V_{B} can be constant during operation, but can be adjusted and/or calibrated to accommodate temperature changes within the optical modulator 144. For example, a smaller bias potential can be set when the respective modulator is hotter. The polarity of bias voltage V_{B} with respect to ground may be selected for convenience of implementation. Here, reverse biasing of the optical modulators 130, 132 corresponds to a negative bias voltage V_{B}- (e.g., the-P doped terminal is at a lower potential than the N-doped terminal, of both the P-i-N EAM and N-i-P EAM modulators).

The optical modulator 130 can be a P-i-N EAM modulator in which the p-type region of the optical modulator 130 is electrically connected to the wire bond 142 in its respective signal chain and the n-type region of the optical modulator 130 is electrically connected to laser ground 136. The optical modulator 132 can be an N-i-P EAM modulator in which the n-type region of the optical modulator 132 is electrically connected to the wire bond 142 in its respective signal chain and the p-type region of the optical modulator 130 is electrically connected to ground 136.

For a typical P-i-N EAM 130, a typical total optical power loss under modulation, in one example is about -1.5 dB in an on state and -6.5 dB in an off state, to provide an extinction ratio of 5 dB.

Because the P-i-N EAM 130 and N-i-P EAM 132 are connected optically in series, i.e., the light from optical source 110 passes through both P-i-N EAM 130 and N-i-P EAM 132 sequentially, a larger distinction can be imparted onto the optical signal between high and low modulation, i.e., it achieves a larger extinction ratio. Accordingly, the two modulator sections work together, where both get more deeply reverse biased at the same time, so that the absorption from both is additive. And, both modulator sections become more transparent at the same time, when the reverse bias on both gets more shallow. Alternatively, the modulator pair can be configured to provide a conventional magnitude of the extinction ratio, but where this is achieved with a substantially reduced peak to peak RF voltage swing, which reduces the power dissipation within the high-speed RF driver. Yet another advantage is that example disclosed configurations enable reduced sensitivity to crosstalk with neighboring circuit elements, and, when compared with conventional single-ended absorption modulators, emits reduced electro-magnetic radiation that can degrade the performance of neighboring circuits, as a consequence of the symmetric electrical voltage swing differential drive and chip layout. The modulation bandwidth of disclosed example transmitting devices 200 (or optical modulators 144) can be 25% higher than for a pseudo-differential EML (where one RF arm is connected to a termination resistor) that is disposed with the same material system and operational constraints, and moreover for a moderately reduced optical modulation amplitude and extinction ratio, the modulation bandwidth of disclosed example transmitting devices 200 (or optical modulators 144) can exceed that a fully differential EML disposed within the same material system.

Passive RF termination networks 134 (134a, 134b) may be respectively electrically connected across the P-i-N EAM 130 and N-i-P EAM 132. The RF termination networks 134a, 134b electrically terminate the high-frequency circuit, including differential amplifier 102, to prevent unwanted reflections and and/or standing waves. The passive RF termination networks 134a, 134b can include, for example, a resistor 114, a resistor 116, a capacitor 118, and off-chip capacitors 120, although other matching and filtering components may also be included. Although the RF termination network 134a and RF Termination network 134b are shown using the same configuration and component numbering, they need not be the same. One or more of the RF termination networks 134a, 134b passive components may be advantageously located on the same chip or substrate 128 (on-chip) as the optical modulators 130, 132 due to similar semiconductor forming processes, which can contribute to efficient manufacturing and space usage and is a further advantage of embodiments of the present disclosure. That is to say that the resistive and capacitive on-chip elements 128 are electrically connected to and formed over or on the same substrate that the optical modulators 130, 132 are connected to / formed over. As shown, the resistors 114, 116, and capacitor 118 are within the on-chip elements 128, and capacitors 118 are also located on-chip 128. The resistance of the resistors 114, in one example, is about 45 Ohms (Ω), the resistance of resistors 116 can be, in one example, about 2 Ω, the capacitance of capacitors 118 can be, in one example, about 30 picofarads (pF), and the capacitance of off-chip capacitors 120 can be, in one example, about 100 nano-farads (nF).

The circuit 100 provides the rapidly-modulated potential that drives optical modulators 130, 132. The circuit 100, including the RF termination network 134a, 134b can minimize cross talk by terminating at least a portion of the high-frequency signal on the same substrate, i.e., within on-chip elements 128, that the optical modulators 130, 132 are connected to. Locating all of the termination components off-chip, or off the substrate that the optical modulators 130, 132 are connected to, creates opportunities for cross talk, by coupling high-frequency signal into the circuits of other channels. The circuit 100 can reduce cross talk by effectively terminating the high-frequency signal on the same substrate as the optical modulators 130, 132. However, it may not be practical to incorporate the fully required capacitance, e.g., a capacitor as large as capacitors 120, into the structure deposited on the same substrate as the optical modulators 130, 132 as doing so can add unwanted inductance. Instead, in one example, a portion of the RF termination networks 134a, 134b, e.g., capacitors 118 may be located on the same substrate as the optical modulators 130, 132, while other, e.g., capacitors 120 are not. Together, the capacitors 118, 120 filter the RF signals 104, 106 while allowing the DC bias potential to pass through during operation.

The RF termination networks 134a, 134b can include the inductance of a connector 122 between capacitors 118, 120 in determining the appropriate values of the RF termination network 134a, 134b. By way of example, connectors 122 can be made with wire bonds. At high frequencies, the inductance of the connectors 122 means the termination of the modulated potential across optical modulators 130, 132, effectively includes the smaller capacitors 120 respectively. This behavior helps to overcome the inherent frequency dependent loss in the RC circuit and thus maintains a desired modulation potential at higher frequencies. For example, at frequencies above 2GHz.

To further overcome frequency dependent losses, connectors 140 (which may be, for example, wire bonds) between optical modulator 144 and resistors 114 could deliberately be made more inductive. Connectors 140 may be formed with inductance of a few hundred pico-henry (pH). For example, an inductance of 300 pH, which would correspond to a wire bond length of about 700 µm. At higher frequencies, this inductance maintains a desired differential potential across optical modulators 130, 132. Circuit 100 thus includes optical modulators 130, 132 providing more consistent absorption changes across a broader operation bandwidth through the use of inductive connectors 140, 122.

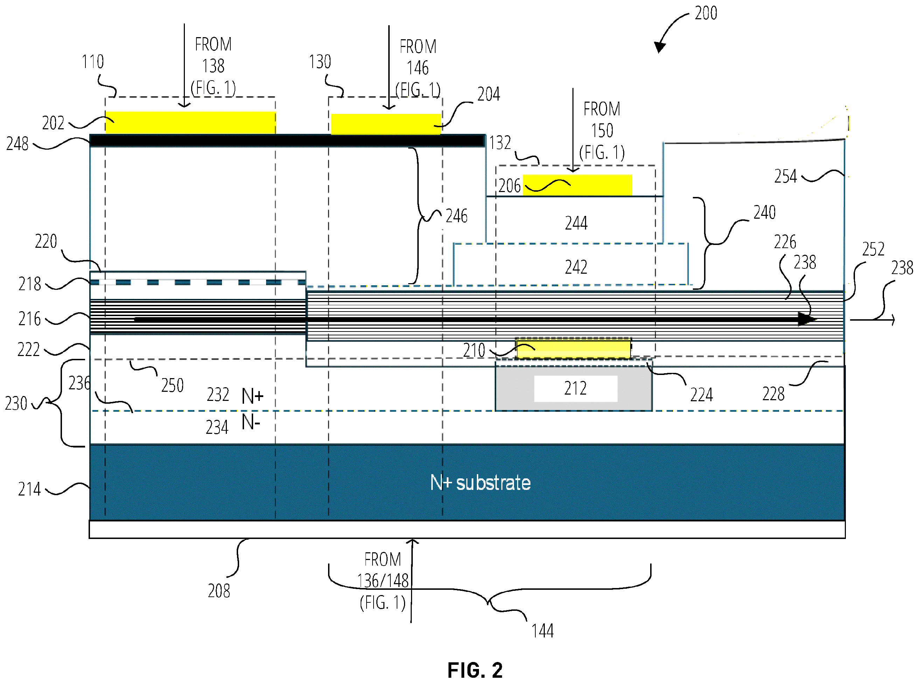

FIGS. 2-3 are a side and perspective views of an example transmitting device 200, corresponding to the circuit 100 in FIG. 1, illustrating the different layers used in an example structure of the transmitting device 200; some components from circuit 100 are omitted from FIGs. 2-3. Like reference numerals are used to represent like elements. In some embodiments, transmitting device 200 can comprise an optical source 110 integrated into the transmitting device 200; here optical source 110 is depicted as a semiconductor laser. The transmitting device 200 includes an optical modulator 144 (including first and second modulator sections 130, 132).

For purposes of this disclosure the standard naming convention will apply in which an "n" or "N" will denote an n-type dopant type or a semiconductor doped with an n-type dopant, a "p" or "P" will denote a p-type dopant type or a semiconductor doped with an p-type dopant, and an "i" or "I" will denote an intrinsic, non-doped, or minimally doped semiconductor. The use of "+" or "-" with respect disclosed dopant types will denote relative doping. For example, an N+ material next to an N- material will denote that the N+ material has more n-type dopant than the N- material. Further, the order of the letters / dopant naming convention will denote the vertical (as shown in FIGs. 2-9) nominal order of semiconductor types for each section from the top layer towards the bottom of the sheet (as shown in the examples, toward the substrate).

The first and second modulator sections 130, 132 have opposite orders of dopant type arrangement within their respective doped semiconductor layers as compared to each other. Throughout this disclosure the first modulator section 130 (in the direction of optical propagation 238) will be described as having a P-i-N configuration (i.e., P-i-N EAM 130) while the second modulator section will be described as having an N-i-P configuration (i.e., N-i-P EAM 132). However, this order can be reversed, e.g., N-i-P followed by P-i-N. Further, the optical source 110 will be depicted in a P-i-N configuration, i.e., the same type configuration order as P-i-N EAM 130, which can have ease of construction benefits. However, other configurations can use an N-i-P optical source 110 configuration and be the same or a different type configuration as the first modulator section 130.

The P-i-N EAM 130, and N-i-P EAM 132, and optionally optical source 110, are positioned on a shared substrate depicted as N+ substrate 214 for the current example transmitting device 200. When the optical source 110 emits light, the light travels through an active region 216 of the optical source 110, is transmitted into a modulator active region 226 that is optically in-line with and adjacent to the active region 216 of the optical source 110. The modulator active region 226 can include one or more quantum wells.

In the configuration of 200 shown in FIGS. 2-3, when electric potential is applied to the optical source 110, e.g., between laser anode 202 and it's cathode (e.g., shown as a shared laser and P-i-N EAM cathode 208), a stream of photons (laser light) is emitted by the active region 216 that propagates laterally from left to right through the length of the active region 216 as an optical propagation 238. The optical propagation 238 is then modulated sequentially by each of P-i-N EAM 130 and N-i-P EAM 132 (as described above with respect to FIG. 1) before exiting transmitting device 200 at exit facet 252.

Optical source 110 may include an active region 216, a grating 218, a laser anode 202, a laser cathode (shown as a shared laser and P-i-N EAM cathode 208), and a ridge comprised of a p-doped ridge waveguide 246. The p-doped ridge waveguide 246 may span a lateral length of the optical source 110 and P-i-N EAM 130, that the semiconductor layer is shared therebetween, but where the resistivity of the ridge layer itself is sufficiently high that forward voltage bias and current injection is substantially limited to the laser active region to confine the driving current in the optical source 110. This arrangement creates sufficient current density to initiate and maintain lasing. The active region 216 may be an epitaxially-grown (EPI) structure, including layers that define the quantum wells producing the laser light. The optical source 110 may include a feedback structure, for example grating 218 embedded in a p-type layer and close enough to 216 to be within an evanescent field of the laser light. In this arrangement, optical source 110 can be a distributed feedback laser. Grating 218 contributes to selecting a lasing wavelength within a gain spectrum of the active region 216. Other arrangements are also possible. For example, a distributed Bragg reflector laser, having a grating incorporated into a passive waveguide section(s) located at one or both ends of the active region 216. Or alternatively, the optical source 110 may be located off-chip, i.e., not located on the same substrate as optical modulator 144.

Optical source 110 may be connected to an electric potential source (e.g. at laser drive electric potential 138 node of FIG. 1) via laser anode 202 and the laser cathode, which is shown in FIGS. 2-3 as a shared laser and P-i-N EAM cathode 208. The laser and P-i-N EAM cathode 208 is shown spanning the entire base of the transmitting device 200, which can aid in wafer fabrication, and ease of solder die attachment to a carrier. However, in other alternatives, the laser and P-i-N EAM cathode 208 spans only a portion thereof. The laser anode 202 can be positioned on or over the P-doped ridge waveguide 228 with an optional contact layer 248 therebetween to assist in diminishing the semiconductor contact resistance of the laser anode 202. The contact layer 248 may include, for example, P+ doped indium gallium arsenide.

In keeping with standard procedures for the fabrication of a ridge waveguided laser, an etch stop layer 220 can be disposed above the grating layer, to precisely define the height of the ridge waveguide.

As will be more apparent in further discussion below, the optical source 110 can be constructed to share one or more layers with the optical modulator 144, which provides the advantages of easier construction, increased density, and decreased losses. While some optionally shared features are discussed with optical source 110, additional functions and configurations will be discussed below. The optical source 110 can further comprise, for example, an etch stop 250 situated below the laser active region, to define a flat growth plane for the subsequent epitaxial growth of the modulator active region, and an n-type semiconductor layer 230 over substrate 214. In some embodiments, additional laser waveguide confinement layers (not shown) can be included in the layer generally depicted as layer 222.

The etch stop 250 can be a layer that prevents wet chemical etching beyond a certain depth, or it can serve as a marker layer to provide metrology feedback during a dry etch step to reveal when the dry etch has passed a target depth. The n-type semiconductor layer 230 can include an etch stop layer within it (at boundary 236) to define a trench in which a p-doped material 212 (e.g., Mg doped InP) is grown (the formation of which will be discussed below). Although not required for the optical source 110, the shared n-type semiconductor layer 230 may include sub-layers of N- semiconductor layer 234 and N+ semiconductor layer 232 such that the N- semiconductor layer 234 provides a buffer for the p-doped material 212, which will be discussed further below. The n-type semiconductor layer 230 may include a N+/N- boundary 236 between the N+ semiconductor layer 232 and the N- semiconductor layer 234. The boundary 236 can define a trench in which the p-doped material 212 (for the N-i-P EAM 132) is grown. The N- semiconductor layer 234 is grown on top of or over the N+ substrate 214 and the N+ semiconductor layer 232 is grown on top of or over the N- semiconductor layer 234. The N+ semiconductor layer 232, the N- semiconductor layer 234, and the substrate 214 may each include InP.

Optical modulator 144 may include a shared (or separate) modulator active region 226 that is shared with each of the P-i-N EAM 130 and the N-i-P EAM 132 and located vertically between the p-doped ridge waveguide 246 (which is also optionally shared with the optical source 110) and the n-type semiconductor layer 230 to form the P-i-N junction of the P-i-N EAM 130. The modulator active region 226 may include an undoped intrinsic semiconductor material. The P-i-N EAM 130 includes a p-side electrode, depicted as P-i-N EAM anode 204, and an n-side electrode depicted as a shared laser and P-i-N EAM cathode 208 that can extend throughout the entire bottom surface of the chip (transmitting device 200). The P-i-N EAM anode 204 and the laser anode 202 may, optionally, be formed with a contact layer to improve ohmic contact with the p-doped ridge waveguide 246, e.g., contact layer 248. Contact layers may also be used with other cathodes and anodes. The modulator active region 226 can be an epitaxially-grown layered structure that includes quantum wells. P-doped ridge waveguide 246 confines the applied electric field (that is applied to the P-i-N EAM 130) to a portion of the modulator active region 226 below the p-doped ridge waveguide 246 increasing optical modulation by way of absorption. The P-iN EAM 130 of FIGS. 2-3 also includes an additional growth layer (e.g., intrinsic buffer layer 228) that can be included at the start of the epitaxial growth of the modulator active region 226.

The N-i-P EAM 132 includes the modulator active region 226 (optionally shared with the P-i-N EAM 130) and located vertically between an n-doped ridge waveguide 240 and a p-doped material 212 to form the N-i-P junction of the N-i-P EAM 132. The n-doped ridge waveguide 240 can include multiple layers or steps, including a ridge waveguide first step 242 and ridge waveguide second step 244 that can both be included in the epitaxial step for the growth of the modulator active region, and in which the ridge waveguide second step 244 is (optionally) disposed to have a shorter extent along the longitudinal light path than ridge waveguide first step 242. The disposition of the N doped layers 242 and 244 to enable the formation of a 2 step "staircase" can improve topography during formation of transmitting device 200 for subsequent EPI growth thereon. The N-i-P EAM 132 includes an n-side electrode over and/or on the n-doped ridge waveguide 240, depicted as N-i-P EAM cathode 206, and a p-side electrode, depicted as N-i-P EAM anode 210, over and/or on the p-doped material 212. Both the N-i-P EAM anode 210 and the N-i-P EAM anode 210 may be formed over respective semiconductor contact layers to improve ohmic contact with the respective layers, e.g., contact layer 224. Contact layer 224 may include, for example, p-doped indium gallium arsenide. The N-i-P EAM 132 of FIGS. 2-3 also includes an additional growth layer (e.g., intrinsic buffer layer 228) and is formed over the substrate 214 and an N- semiconductor layer 234 between the substrate and the p-doped material 212. The n-doped ridge waveguide 240 is typically n doped with silicon and the p-doped material 212 may comprise indium phosphide with the p-dopant being, for example, magnesium.

The P-i-N EAM anode 204 can be electrically connected to a node such as node 146 in FIG. 1, and the laser and P-i-N EAM cathode 208 can be electrically connected to a node such as laser ground 136 or node 148 FIG. 1. The N-i-P EAM cathode 206 can be electrically connected to a node such as node 150 in FIG. 1 and the N-i-P EAM anode 210 can be electrically connected to a node such as laser ground 136 or node 148, where, as noted earlier, the cathode can extend over the entire lower surface of the chip.

When an electric potential (in the form of signal 104 and inverted signal 106) is applied, respectively, across P-i-N EAM 130 and N-i-P EAM 132 through their respective electrical connections, optical propagation 238 traveling from the optical source 110 through the optical modulator 144 will be modulated in the modulator active region 226 by each of the P-i-N EAM 130 and N-i-P EAM 132. For instance, the signal 104 and inverted signal 106 can include digital data encoded therein, and when the optical propagation 238 enters the modulator active regions 226, each of the P-i-N EAM 130 and N-i-P EAM 132 will modulate the optical propagation 219 in accordance with a change in material absorption that is achieved by the quantum confined stark effect and impart such modulation to the optical propagation 238 for transmission out of the exit facet 252. Facet reflection mitigation features 254, for example, anti-reflection coatings, may also be included on the exit facet 252. Following the transmission through the exit facet 252, the optical propagation 238 can be transmitted through free-space, into an optical fiber, or through another waveguide. For example, an optical fiber connecting the transmitting device 200 to a receiver or transceiver.

It should be noted that the optical transit time through each modulator section (130, 132) is not zero (it is approximately 5 picoseconds). Accordingly it may be advantageous, in some implementations, to introduce a small delay (for example by geometry of one RF line path shape) before the first modulator (P-i-N EAM 130 in the below examples) to better synchronize its absorption action with that of the second modulator section (N-i-P EAM 132 in the below examples). We note further that this delay line might moderately affect electrical reflections from the modulator back to the signal driver (differential amplifier 102), both the "common electrical mode" reflections and/or may generate some asymmetric reflected electrical mode power (quantified as "mode conversion" upon reflection), so it can be advantageous to consider these relevant consequences of design modifications while optimizing the device to include a small electrical delay that offsets RF signal delivery times to the two modulator sections.

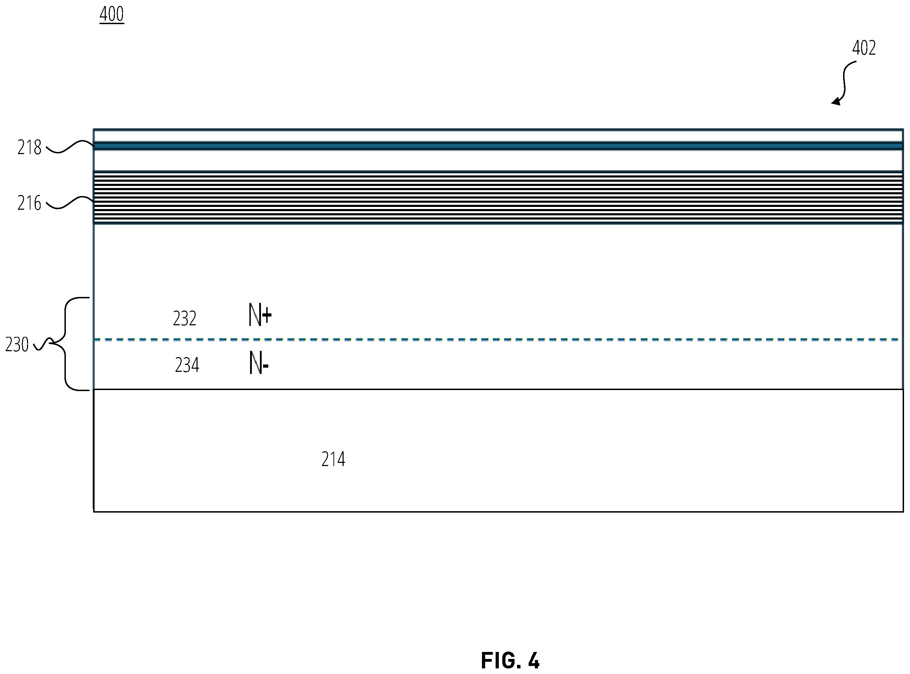

FIGs. 4-9 show an example method of forming the transmitting device 200 of FIGs. 2-3. Like reference numbers refer to like elements. At step 400, an intermediary device stack 402 is provided that is shown including the substrate 214, n-type semiconductor layer 230, laser active region 216 and grating 218 layer (shown prior to writing the grating). The grating 218 layer in this stage preferably includes an InGaAsP alloy sandwiched by an InP layer below and above it. The intermediary device stack 402 may be formed through standard EPI growth processing, for example those used with indium phosphide semiconductor processing. For example, the N- semiconductor layer 234 may be EPI-grown over substrate 214, N+ semiconductor layer 232 may be EPI-grown over N- semiconductor layer 234 followed by the successive formation of active region 216, grating 218 layer, and etch stop layer 220 (FIG. 2). An etch stop layer can be included at the boundary 236 to separate the N+ semiconductor layer 232 and the N- semiconductor layer 234 and function as an etch stop layer during later further processing. Following formation of the grating 218 layer in an EPI-growth step, the grating can be written into the grating 218 layer by disposing a dielectric grating mask onto the wafer surface, which is then exposed by electronic e-beam to define and develop gaps in the grating mask, which then serve to pattern the dry or wet chemical etched removal of a portion of the grating layer material at the openings in the grating mask, in order to form a diffraction grating.

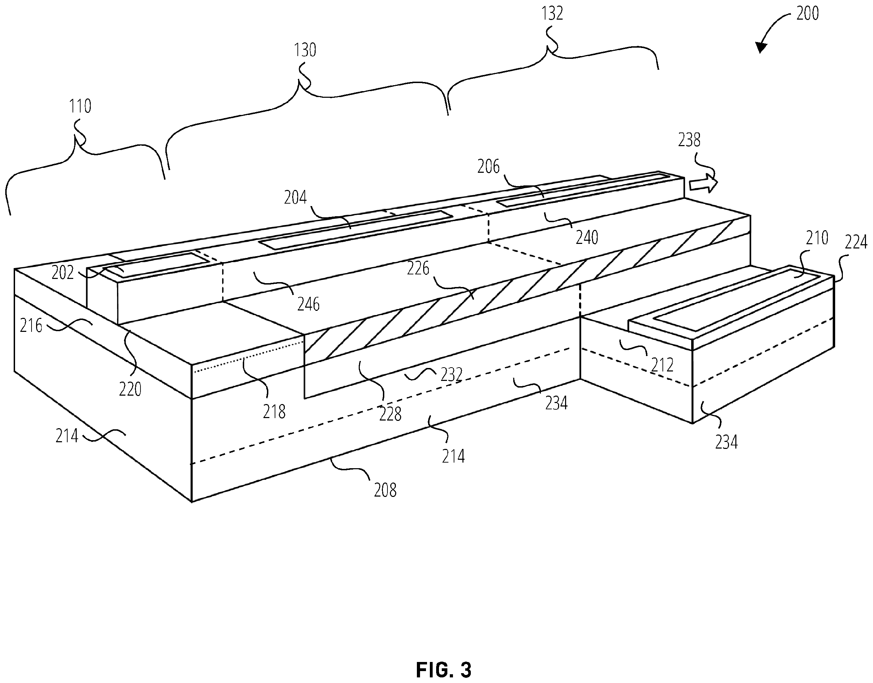

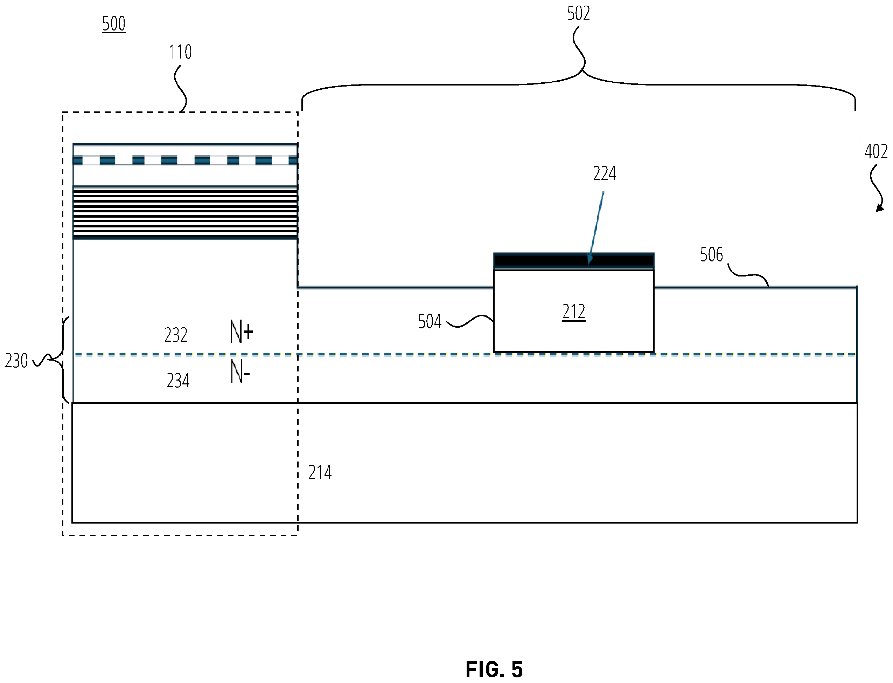

At step 500 (FIG. 5), a portion 502 of the intermediary device stack 402 is removed via etching to clear portions for the optical modulator 144, while leaving the portion that will become parts of the optical source 110. Additional etching is conducted into the N+ semiconductor layer 232 to form a trench 504, optionally down to the boundary 236. Trench may have, for example a depth of about 0.3 microns. Into the trench, the p-doped material 212 (e.g., Mg-doped InP) is deposited up to about even with etched surface (about 0.3 microns thick), with an optional contact layer 224 (e.g., p-doped indium gallium arsenide) added on top thereof, for example having an additional thickness of about 0.2 microns. FIG. 5 shows the p-doped material 212 being formed slightly proud of the 506, which is also an option. In one example, the p-doped material 212 and contact layer 224 are grown wider (into and out of the page) than the modulator active region 226, which is shown in the perspective view of FIG. 3 to provide electrical access for formation of the N-i-P EAM anode 210.

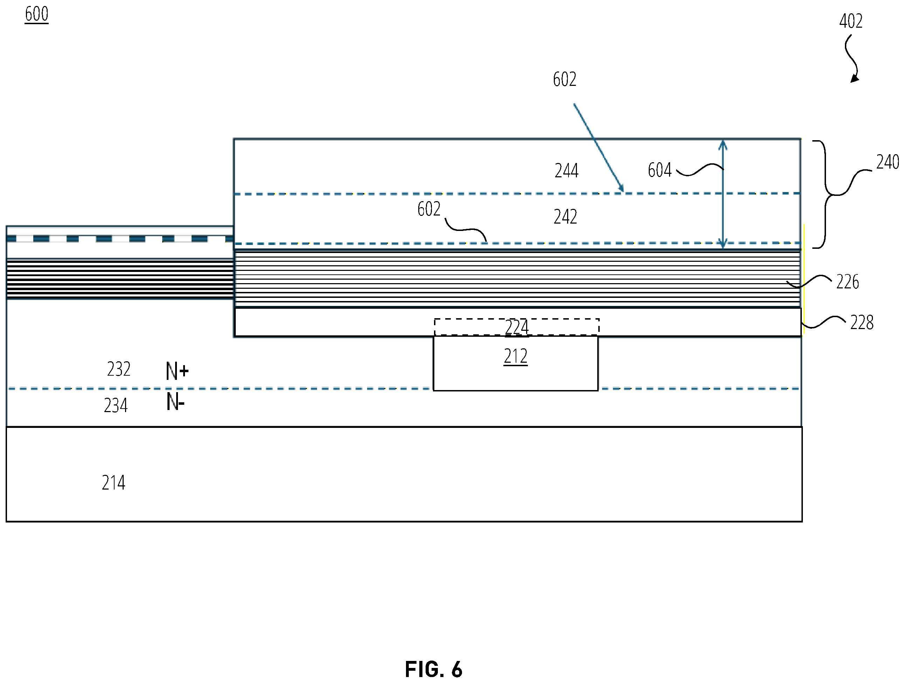

At step 600 (FIG. 6), the contact layer 224 is partially removed (under what will form the modulator active region 226) leaving a portion thereof (toward the direction out of the page) for electrical contact (see, FIG. 3). An intrinsic buffer layer 228 is EPI-grown over the exposed p-doped material 212 (which also forms a flat layer for further growth), followed by the modulator active region 226 over and on top of the intrinsic buffer layer 228, and the n-doped ridge waveguide 240 formed over and on top of the modulator active region 226. The modulator active region 226 and the layers epitaxially grown below (intrinsic buffer layer 228) and above it (n-doped ridge waveguide 240), may have, in one example, a height of 1.25um above the surface upon which the epitaxial step begins. Forming the n-doped ridge waveguide 240 may optionally include the successive formation of ridge waveguide first step 242 and ridge waveguide second step 244. By way of example, n-doped ridge waveguide 240 may be formed to have a thickness 604 of about 0.85 microns evenly split between ridge waveguide first step 242 and ridge waveguide second step 244 (about 0.425 microns each). In alternative example the thickness of each of the ridge waveguide first step 242 and the ridge waveguide second step 244 are not the same. Etch stops 602 may be included under each of ridge waveguide first step 242 and 244 to assist with future processing.

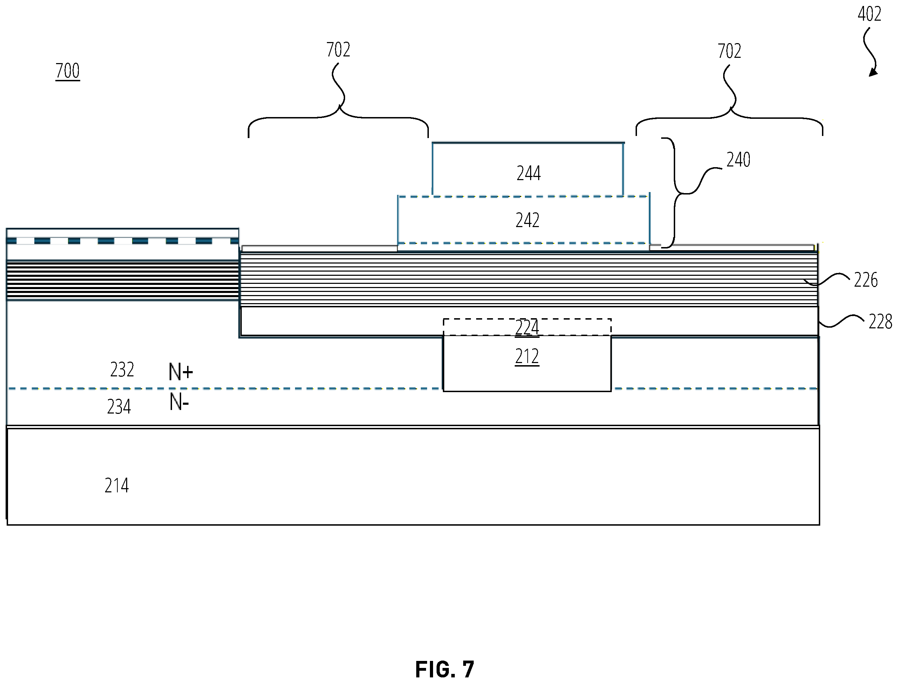

At step 700 (FIG. 7), portions 702 of n-doped ridge waveguide 240 are etched away. In one example, a first layer of n-doped ridge waveguide 240 is etched away to a first etch stop 602 (FIG. 6) to form ridge waveguide second step 244 and then a second layer of n-doped ridge waveguide 240 is etched away to a second etch stop 602 to form ridge waveguide first step 242. The resulting structure following the etchings is the n-doped ridge waveguide 240 shown in FIGs. 2-3 and 7.

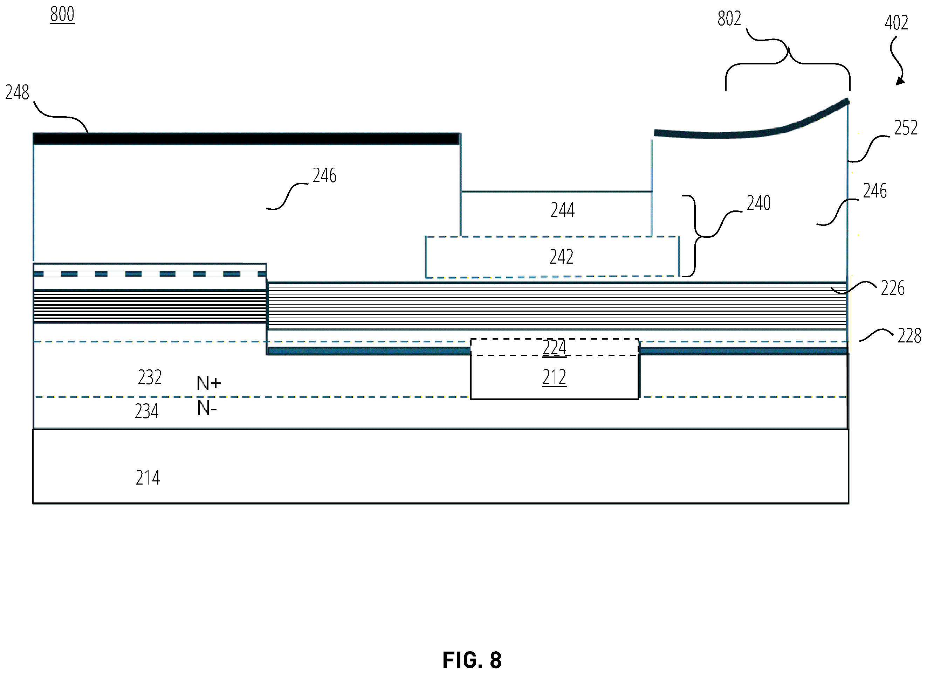

At step 800 (FIG. 8) p-doped ridge waveguide 246 is formed (e.g., EPI-grown) and, optionally capped with contact layer 248. Optionally, additional EPI-growth can be included toward the exit facet 252 such that the p-doped ridge waveguide 246 increases in thickness toward the exit facet 252 to increase the waveguide cross section to facilitate the formation of a spot size converter 802 for the optical propagation 238.

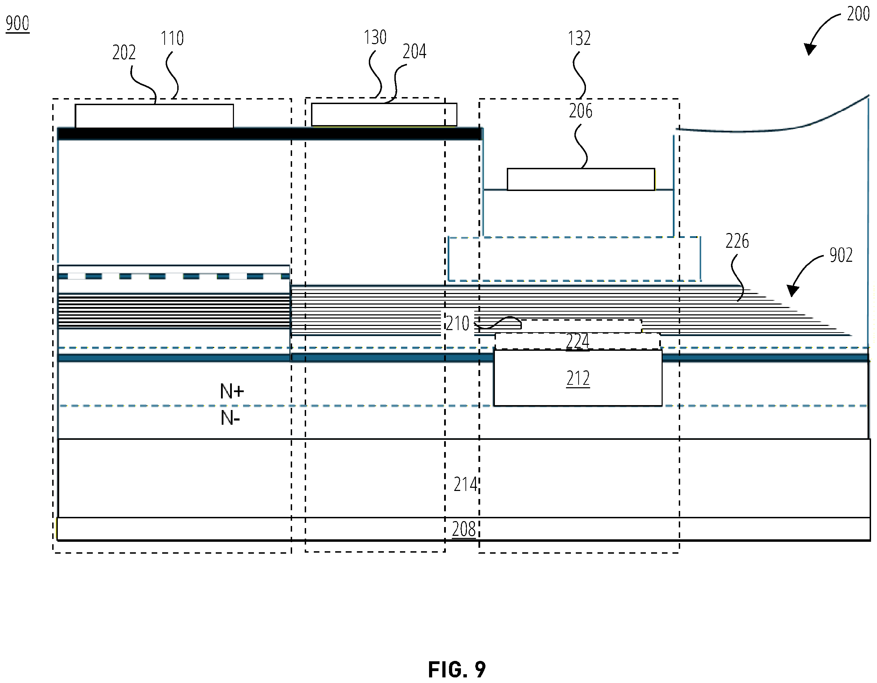

At step 900 (FIG. 9) the anodes and cathodes are formed (i.e., laser anode 202, P-i-N EAM anode 204, N-i-P EAM cathode 206, N-i-P EAM anode 210 and laser and P-i-N EAM cathode 208) to establish electrical contact areas for the transmitting device 200 and thus forming the optical source 110, the P-i-N EAM 130, and the N-i-P EAM 132, respectively.

An optional taper 902 of the modulator active region 226 is shown in FIG. 9 that can be formed during or in addition to the etching steps of step 700 (FIG. 7). Optionally, tapering the modulator active region 226 can aid in expanding the mode profile to increase the mode spot size, forming a spot size converter 802, which reduces beam divergence to reduce losses when coupling the output light beam through lens systems to an optical fiber waveguide.

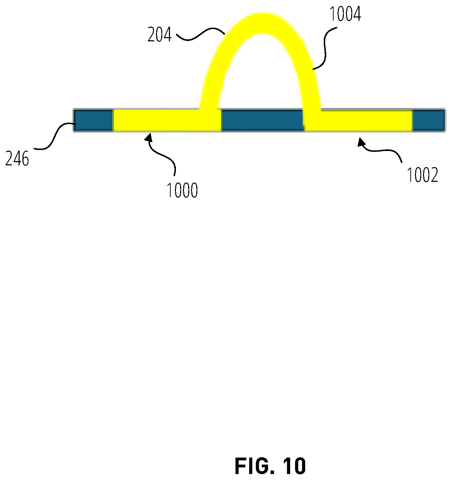

While the P-i-N EAM anode 204 and N-i-P EAM cathode 206 are shown as a single linear conductor in FIGs. 2-3 and 9, other alternatives are also available. For example, each of P-i-N EAM anode 204 and N-i-P EAM cathode 206 may each include a multi-section type contact including 2 or more contacts for each connection, with looping metal traces placed between them in order to add a desired amount of inductance. An example is shown in FIG. 10, shows p-doped ridge waveguide 246 looking from the top down (into the page) toward the substrate. Other features are removed for clarity. As shown the P-i-N EAM anode 204 is electrically connected to p-doped ridge waveguide 246 at a first connection 1000 and a second connection 1002 with an inductive connector 1004 (or loops) therebetween. A similar alternative connection can be made with respect N-i-P EAM cathode 206 and n-doped ridge waveguide 240. Such additional inductive loops may be beneficial on electro-absorption modulator types. However, inductive connectors need to be longer when implemented on n-type substrates given that a conductive substrate diminishes the inductance of a loop trace when compared to a semi insulating or insulating substrate. Alternatively, a dielectric such as benzocyclobutene (BCB) under the inductive connectors can be used when implemented on conductive substrates.

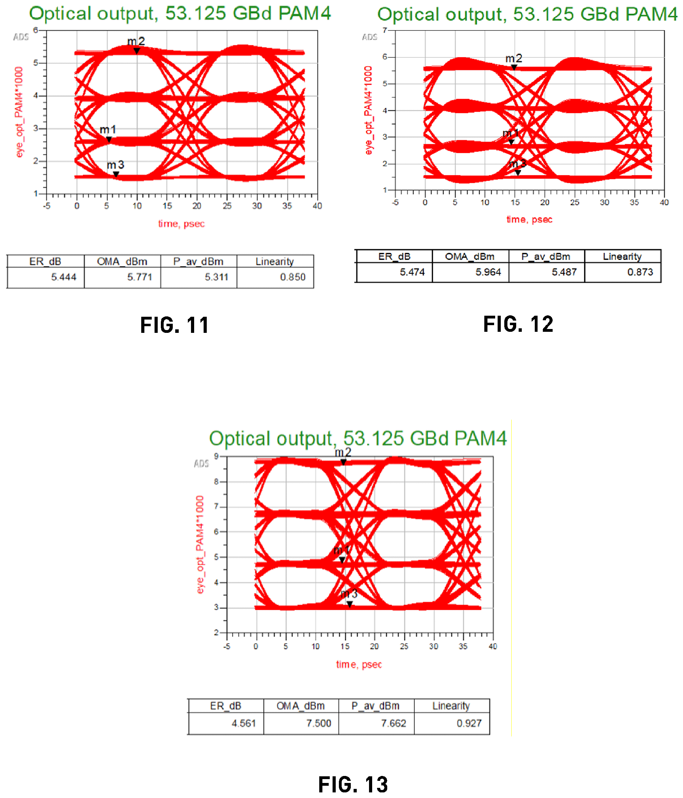

FIG. 11 shows an eye diagram corresponding to a simulation of a pseudo differential EML transmitting device (not shown). The pseudo differential EML transmitting device may comprise a single EML circuit connected to a first output terminal of a differential operational amplifier and a differential signal dummy circuit connected to a second output terminal of the differential operational amplifier. The differential signal dummy circuit can be terminated with a 43 ohm resistor. The single EML circuit may comprise gain peaking inductive wire bonds that are 700 micrometers (700 µm) in length, a 45 Ohms termination resistor that is implemented on the same chip that the EML is on, and a multi-quantum well (MQW) stack comprising 10 quantum wells.

The eye diagram of FIG. 11 corresponds to a simulation of the pseudo differential EML transmitting device within an 80° Celsius environment while transmitting PAM4 modulated symbols at a symbol rate of 53.125 gigabaud (GBd). Given these conditions, the pseudo differential EML transmitting device may transmit the PAM4 symbols with an extinction ration (ER) of 5.444 decibels (dB), an optical modulation amplitude (OMA) of 5.771 decibel milliwatts (dBm), an average power of 5.311 dBm, and eye linearity (defined as the ratio of the smallest eye to the largest eye within the PAM4 eye diagram) of 0.850.

FIG. 12 shows a simulated eye diagram corresponding to a transmitting device 200 within the circuit 100 with the following parameters: the inductive wire bond 142 and gain peaking connector 140 are 300 and 600 µm in length, respectively; the RF termination resistors 114 are each 45 Ohms; and modulator active region 226 is a multiple quantum well (MQW) stack comprising 10 quantum wells. The eye diagram of FIG. 12 is simulated in an 80° Celsius environment while transmitting PAM4 modulated symbols at a symbol rate of 53.125 gigabaud (GBd). Given these conditions, the transmitting device 200 within the circuit 100 may transmit the PAM4 symbols with an extinction ration (ER) of 5.474 decibels (dB), an optical modulation amplitude (OMA) of 5.964 decibel milliwatts (dBm), an average power of 5.487 dBm, and linearity of 0.873. Because the transmitting device 200 is a series differential EML, it does not include the differential signal dummy circuit that is in the pseudo differential EML transmitting device described above with respect to FIG. 11. Because the circuit 100 includes two EAM circuits (differential to each other) as opposed to just one as described above with respect to the pseudo differential EML transmitting device, the ER, OMA, average power, and linearity metrics are higher for the series differential EML circuit 100 shown in FIG. 12 as compared to that of FIG. 11.

FIG. 13 shows a simulated eye diagram corresponding to a transmitting device 200 within the circuit 100 with the following parameters: the inductive connector 140 and wire bond 142 are 470 µm and 720 µm in length respectively; the RF termination resistors 114 are each 45 Ohms; and modulator active region 226 is a MQW stack comprising 10 quantum wells. Additionally the simulation also simulates the n-doped ridge waveguide 240 and the p-doped ridge waveguide 246 shown in FIG. 2. The eye diagram of FIG. 13 is simulated in an 80° Celsius environment while transmitting PAM4 modulated symbols at a symbol rate of 53.125 gigabaud (GBd). Given these conditions, the transmitting device 200 within the circuit 100 may transmit the PAM4 symbols with an extinction ration (ER) of 4.561 decibels (dB), an optical modulation amplitude (OMA) of 7.500 decibel milliwatts (dBm), an average power of 7.662 dBm, and linearity of 0.972. Because the simulation includes a simulation of the contribution of the n-doped ridge waveguide 240 and the p-doped ridge waveguide 246, the ER, OMA, average power, and linearity metrics are higher for a series differential EML circuit 100 including the ridge waveguides as opposed to the simulation of a series differential EML circuit that does not include the ridge waveguides. The OMA at the output of the P-i-N EAM is 6.380 dBm and the OMA of the N-i-P EAM 132 is 7.871 dBm.

The Series Differential EML disclosed herein (e.g., transmitting devices 200) have a higher bandwidth as can be seen by the amplitude of the eye opening of the eye diagrams of FIGs. 12-13 relative to the amplitude of the eye opening of the eye diagram of FIG. 11. In general the greater the amplitude of the eye openings of an eye diagram, the greater the bandwidth of the transmitting device. This is directly attributable to the series differential EMLs configurations described with references to transmitting devices 200 and circuit 100.

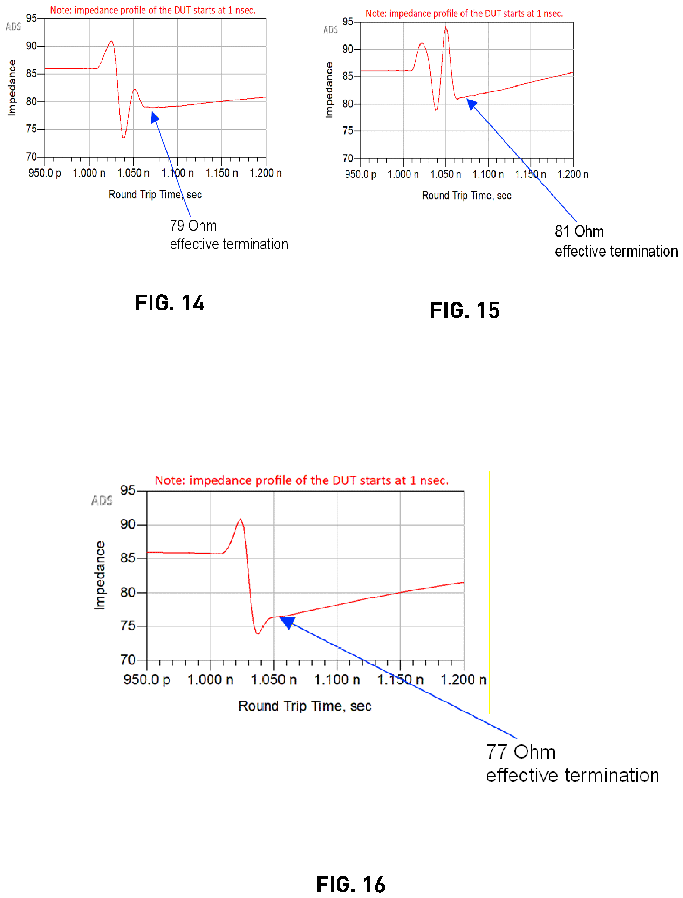

FIGs. 14-16 shows effective termination impedance graphs associated with the pseudo differential EML transmitting device, and the transmitting devices 200 discussed, respectively, with FIGs. 11-13 as a function of time. The Series Differential EML shows an impedance which is well matched to target source impedance leading to low electrical return loss.

The series differential EML transmitting device disclosed herein also has a 10 dB lower mode conversion, and a lower crosstalk (XT) compared to other circuits with a transceiver. Disclosed series differential EML provides for a 25% higher bandwidth as compared to the pseudo differential EML.

Unless specific arrangements described herein are mutually exclusive with one another, the various implementations described herein can be combined in whole or in part to enhance system functionality or to produce complementary functions. Likewise, aspects of the implementations may be implemented in standalone arrangements. Thus, the above description has been given by way of example only and modification in detail may be made within the scope of the present invention.

With respect to the use of substantially any plural or singular terms herein, those having skill in the art can translate from the plural to the singular or from the singular to the plural as is appropriate to the context or application. The various singular/plural permutations may be expressly set forth herein for sake of clarity. A reference to an element in the singular is not intended to mean "one and only one" unless specifically stated, but rather "one or more." Moreover, nothing disclosed herein is intended to be dedicated to the public regardless of whether such disclosure is explicitly recited in the above description.

In general, terms used herein, and especially in the appended claims (e.g., bodies of the appended claims) are generally intended as "open" terms (e.g., the term "including" should be interpreted as "including but not limited to," the term "having" should be interpreted as "having at least," the term "includes" should be interpreted as "includes but is not limited to," etc.). Also, a phrase presenting two or more alternative terms, whether in the description, claims, or drawings, should be understood to include one of the terms, either of the terms, or both terms. For example, the phrase "A or B" will be understood to include the possibilities of "A" or "B" or "A and B."

The present invention may be embodied in other specific forms without departing from its spirit or essential characteristics. The embodiments described are to be considered in all respects only as illustrative and not restrictive. The scope of the invention is, therefore, indicated by the appended claims rather than by the foregoing description. All changes which come within the meaning and range of equivalency of the claims are to be embraced within their scope.

Furter aspects of the invention are described in the following clauses:
Clause 1. An optical transmitting device comprising;
   an optical source adapted to emit an optical beam;
   a substrate;
   a first electro-absorption modulator (EAM) arranged on the substrate and configured to modulate the optical beam in response to an RF signal, wherein the first EAM includes a first semiconductor layer over the substrate and being doped with a first dopant type, a second semiconductor layer over the first semiconductor layer and being doped with a second dopant type opposite the first dopant type, and an active region between the first semiconductor layer and the second semiconductor layer of the first EAM; and
   a second EAM arranged on the substrate to receive the optical beam from the first EAM and configured to modulate the optical beam in response to an inverted signal of the RF signal,
   wherein the second EAM includes a first semiconductor layer over the substrate and being doped with the second dopant type, a second semiconductor layer over the first semiconductor layer and being doped with the first dopant type, and an active region between the first semiconductor layer and the second semiconductor layer of the second EAM.
Clause 2. The optical transmitting device of clause 1, wherein the first dopant type is n-type, the second dopant type is p-type, the first EAM is a P-i-N EAM, and the second EAM is an N-i-P EAM.
Clause 3. The optical transmitting device of clause 2, wherein the active region of the P-i-N EAM and the active region of the N-i-P EAM forms a shared modulator active region.
Clause 4. The optical transmitting device of clause 2, wherein the second semiconductor layer of the P-i-N EAM is a p-doped ridge waveguide.
Clause 5. The optical transmitting device of clause 4, further comprising a P-i-N EAM anode formed over the p-doped ridge waveguide.
Clause 6. The optical transmitting device of clause 5, further comprising a contact layer between the P-i-N EAM anode and the p-doped ridge waveguide
Clause 7. The optical transmitting device of clause 4, further comprising an exit facet, wherein the p-doped ridge waveguide increases in thickness in a direction toward the exit facet.
Clause 8. The optical transmitting device of clause 7, wherein the active region of the second EAM is tapered in a direction toward the exit facet.
Clause 9. The optical transmitting device of clause 4, wherein the first semiconductor layer of the N-i-P EAM is formed within a trench of the first semiconductor layer of the P-i-N EAM.
Clause 10. The optical transmitting device of clause 4, wherein the second semiconductor layer of the N-i-P EAM is an n-doped ridge waveguide.
Clause 11. The optical transmitting device of clause 10, wherein the n-doped ridge waveguide has a second step over a first step, the second step having a longitudinal extent that is shorter than the first step.
Clause 12. The optical transmitting device of clause 10, further comprising N-i-P EAM cathode formed over the n-doped ridge waveguide.
Clause 13. The optical transmitting device of clause 12, further comprising a contact layer between the N-i-P EAM anode (210) and the first semiconductor layer of the second EAM.
Clause 14. The optical transmitting device of clause 1, wherein the substrate is a doped substrate being doped with the first dopant type.
Clause 15. The optical transmitting device of clause 14, wherein the first semiconductor layer of the first EAM comprises a first sub-layer over a second sub-layer and the first sub-layer has a higher concentration of the first dopant type than the second sub-layer.
Clause 16. The optical transmitting device of clause 1, wherein the optical source is arranged on the substrate.
Clause 17. The optical transmitting device of clause 16, wherein the optical source is a laser comprising an active region and the active region of the laser optically aligns with the active region of the first EAM.
Clause 18. The optical transmitting device of clause 1, wherein the second semiconductor layer of the first EAM is electrically connected to a first output of a differential amplifier, the second semiconductor layer of the second EAM is electrically connected to a second output of the differential amplifier and the second output being an inverted output of the first output.
Clause 19. The optical transmitting device of clause 18, wherein the second semiconductor layer of the first EAM is electrically connected to a first radio frequency (RF) termination network and the second semiconductor layer of the second EAM is electrically connected to a second RF termination network.

## Claims

1. An optical transmitting device comprising:
an optical source adapted to emit an optical beam;
a substrate;
a first electro-absorption modulator (EAM) arranged on the substrate and configured to modulate the optical beam in response to an RF signal, wherein the first EAM includes a first semiconductor layer over the substrate and being doped with a first dopant type, a second semiconductor layer over the first semiconductor layer and being doped with a second dopant type opposite the first dopant type, and an active region between the first semiconductor layer and the second semiconductor layer of the first EAM; and
a second EAM arranged on the substrate to receive the optical beam from the first EAM and configured to modulate the optical beam in response to an inverted signal of the RF signal,
wherein the second EAM includes a first semiconductor layer over the substrate and being doped with the second dopant type, a second semiconductor layer over the first semiconductor layer and being doped with the first dopant type, and an active region between the first semiconductor layer and the second semiconductor layer of the second EAM.

2. The optical transmitting device of claim 1, wherein the first dopant type is n-type, the second dopant type is p-type, the first EAM is a P-i-N EAM, and the second EAM is an N-i-P EAM.

3. The optical transmitting device of claim 2, wherein the active region of the P-i-N EAM and the active region of the N-i-P EAM forms a shared modulator active region.

4. The optical transmitting device of claim 2 or 3, wherein the second semiconductor layer of the P-i-N EAM is a p-doped ridge waveguide.

5. The optical transmitting device of claim 4, further comprising a P-i-N EAM anode formed over the p-doped ridge waveguide, preferably further comprising a contact layer between the Pi-N EAM anode and the p-doped ridge waveguide.

6. The optical transmitting device of claim 4 or 5, further comprising an exit facet, wherein the p-doped ridge waveguide increases in thickness in a direction toward the exit facet.

7. The optical transmitting device of claim 6, wherein the active region of the second EAM is tapered in a direction toward the exit facet.

8. The optical transmitting device of any one of claims 4-7, wherein the first semiconductor layer of the N-i-P EAM is formed within a trench of the first semiconductor layer of the P-i-N EAM.

9. The optical transmitting device of any one of claims 4-8, wherein the second semiconductor layer of the N-i-P EAM is an n-doped ridge waveguide.

10. The optical transmitting device of claim 9, wherein the n-doped ridge waveguide has a second step over a first step, the second step having a longitudinal extent that is shorter than the first step.

11. The optical transmitting device of claim 9 or 10, further comprising an N-i-P EAM cathode formed over the n-doped ridge waveguide, preferably further comprising a contact layer between the N-i-P EAM anode (210) and the first semiconductor layer of the second EAM.

12. The optical transmitting device of any one of claims 1-11, wherein the substrate is a doped substrate being doped with the first dopant type, wherein, preferably, the first semiconductor layer of the first EAM comprises a first sub-layer over a second sub-layer and the first sub-layer has a higher concentration of the first dopant type than the second sub-layer.

13. The optical transmitting device of any one of claims 1-12, wherein the optical source is arranged on the substrate, wherein, preferably, the optical source is a laser comprising an active region and the active region of the laser optically aligns with the active region of the first EAM.

14. The optical transmitting device of any one of claims 1-13, wherein the second semiconductor layer of the first EAM is electrically connected to a first output of a differential amplifier, the second semiconductor layer of the second EAM is electrically connected to a second output of the differential amplifier and the second output being an inverted output of the first output.

15. The optical transmitting device of claim 14, wherein the second semiconductor layer of the first EAM is electrically connected to a first radio frequency (RF) termination network and the second semiconductor layer of the second EAM is electrically connected to a second RF termination network.
